# EUROPEAN PATENT APPLICATION

(11) **EP 4 109 557 A1**
(43) Date of publication of application: **28.12.2022**
(21) Application number: 22179997.6
(22) Date of filing: 20.06.2022
(51) Int. Cl.: H01L 29/775, H01L 21/336, H01L 29/06, H01L 29/417, H01L 29/423, H01L 29/165, H01L 29/10, H01L 29/16, H01L 29/20, B82Y 10/00

(54) **TRANSISTORS WITH SOURCE & DRAIN ETCH STOP**

(30) Priority: 25.06.2021 US 202117358903
(71) Applicant: INTEL Corporation, Santa Clara, CA 95054 (US)
(72) Inventor: MEHANDRU, Rishabh, Portland, 97221 (US); CEA, Stephen, Hillsboro, 97124 (US); GHANI, Tahir, Portland, 97229 (US); KEYS, Patrick, BEAVERTON, 97006 (US); LILAK, Aaron D., Beaverton, 97007 (US); MURTHY, Anand, Portland, 97229 (US); WEBER, Cory, Hillsboro, 97124 (US)
(74) Representative: 2SPL Patentanwälte PartG mbB

(57) **Abstract**

Integrated circuitry comprising transistor structures with a source/drain etch stop layer to limit the depth of source and drain material relative to a channel of the transistor. A portion of a channel material layer may be etched in preparation for source and drain materials. The etch may be stopped at an etch stop layer buried between a channel material layer and an underlying planar substrate layer. The etch stop layer may have a different composition than the channel layer while retaining crystallinity of the channel layer. The source and drain etch stop layer may provide adequate etch selectivity to ensure a source and drain etch process does not punch through the etch stop layer. Following the etch process, source and drain materials may be formed, for example with an epitaxial growth process. The source and drain etch stop layer may be, for example, primarily silicon and carbon.

## Description

### BACKGROUND

Demand for higher performance integrated circuits (ICs) in electronic device applications has motivated increasingly dense transistor architectures. For examples, stacked gate-all-around (GAA) transistor structures, such as ribbon or wire (RoW) structures, include a plurality of channel regions that are in a vertical stack with one transistor channel over another.

Channel regions of transistor structures are often coupled to epitaxial source and drain semiconductor materials that are regrown from crystalline seeding surfaces exposed by etching through semiconductor fin material(s) that are replaced with the heavily doped source and drain semiconductor material. The source and drain etch process(es) for stacked transistor structures remove the multiple differing semiconductor material layers of a fin. Transistor architectures and associated fabrication techniques that improve the control of the source and drain etch process(es) are advantageous for improved transistor performance and yield.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 illustrates an isometric sectional view of a transistor structure including a source and drain etch stop, in accordance with some embodiments;
FIG. 2A illustrates a cross-sectional view of the transistor structure introduced in FIG. 1, in accordance with some embodiments;
FIG. 2B illustrates a second cross-sectional view of the transistor structure illustrated in FIG. 2A, in accordance with some embodiments;
FIG. 2C illustrates a cross-sectional view of the transistor structure illustrated in FIG. 1, in accordance with some alternative embodiments;
FIG. 2D illustrates a second cross-sectional view of the transistor structure illustrated in FIG. 2C, in accordance with some alternative embodiments;
FIG. 3 is a flow diagram illustrating methods fabricating a transistor stack structure with a source and drain etch stop layer, in accordance with some embodiments;
FIG. 4A, 4B and 4C are cross-sectional views through a workpiece processed to include channel materials over a substrate layer with a source and drain stop layer therebetween, in accordance with some embodiments;
FIG. 5A is an isometric view of a fin of stacked semiconductor material layers with a channel mask, in accordance with some embodiments;
FIG. 5B is a t cross-sectional view through a length of the fin illustrated in FIG. 5A, in accordance with some embodiments;
FIG. 6, 7 and 8A are isometric views of a fin of stacked semiconductor material layers following the practice of selected operations from the methods illustrated in FIG. 3, in accordance with some embodiments;
FIG.8B is a first cross-sectional view through a length of the fin illustrated in FIG. 8A, in accordance with some embodiments;
FIG. 8C is a second cross-sectional view through a width of the fin illustrated in FIG. 8A, in accordance with some embodiments;
FIG. 9A is a first cross-sectional view through a length of a transistor stack structure following completion of the methods illustrated in FIG. 3, in accordance with some embodiments;
FIG. 9B is a second cross-sectional view through a width of the transistor stack structure illustrated in FIG. 9A, in accordance with some embodiments;
FIG. 10 illustrates a mobile computing platform and a data server machine employing an IC including transistor structures with a source and drain stop layer, in accordance with embodiments; and
FIG.11 is a functional block diagram of an electronic computing device, in accordance with some embodiments.

### DETAILED DESCRIPTION

Embodiments are described with reference to the enclosed figures. While specific configurations and arrangements are depicted and discussed in detail, it should be understood that this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. It should be understood that these terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause and effect relationship).

The terms "over," "under," "between," and "on" as used herein refer to a relative position of one component or material with respect to other components or materials where such physical relationships are noteworthy. For example in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct physical contact with that second material/layer. Similar distinctions are to be made in the context of component assemblies.

As used throughout this description, and in the claims, a list of items joined by the term "at least one of' or "one or more of' can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

As described further below, a stop layer is buried between transistor channel material layer(s) and an underlying planar substrate layer. The stop layer is advantageously monocrystalline along with the transistor channel material layer(s) and substrate layer. The stop layer has a different chemical composition than the channel material layer(s) and the substrate layer. An etch of the channel material layer(s), for example performed in preparation for the deposition or growth of source and drain materials, is landed on or within the stop layer. The stop layer is therefore more specifically referred to herein as a "source and drain etch stop layer," and is to more precisely control the depth of the source and drain material than is possible with an unlanded source and drain etch that is allowed to advance into the substrate layer. An intervening source and drain etch stop layer is particularly advantageous where the etch of the channel layer(s) is not highly selective to the substrate layer, for example because both the substrate layer and the channel layer(s) have similar composition. Thickness and composition of the source and drain etch stop layer may be predetermined to ensure the source and drain etch process does not punch through and uncontrollably expose the substrate layer.

As the source and drain etch stop layer may remain within a sub-fin below the channel region(s), and be in direct contact with the source and drain materials, the composition of the source and drain etch stop layer may have advantageously high electrical resistivity and/or retard diffusion of dopants from the source and drain material into the etch stop layer and/or underlying substrate layer. Hence, a source and drain etch stop layer in accordance with embodiments may reduce sub-channel (i.e., sub-fin) leakage paths between the source and drain materials both through better control of the source and drain material depth, and by interfacing the source and drain materials with a sub-channel dopant diffusion barrier.

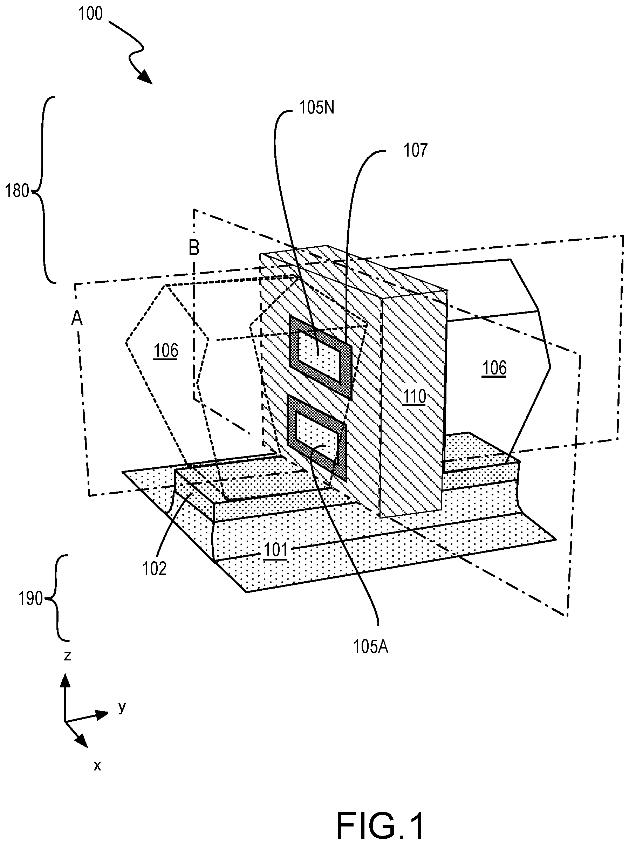

FIG. 1 illustrates an isometric sectional view of a metal-oxide-semiconductor field effect transistor (MO SFET) structure 100 including a source and drain etch stop layer 102, in accordance with some embodiments. Transistor structure 100 has a GAA transistor architecture with a stack of channel regions 105A-105N. Transistor structure 100 is illustrated as including two active channel regions 105A and 105N, but a transistor structure may include a single channel region 105A, or a stack of any larger integer number N of channel regions (e.g., 2, 3, 4, 5... 10... 20, etc.).

An integrated circuit including transistor structure 100 may include any number of metallization levels 180 over a "top" or "front" side of transistor structure 100. The integrated circuit may optionally further include any number of backside metallization levels 190 over a "bottom" or "back" side of transistor structure 100. Channel regions 105A-105N are over a sub-channel material comprising a source and drain etch stop layer 102, which separates channel regions 105A-105N from the back side of transistor structure 100.

Transistor structure 100 may comprises transistors of either positive or negative conductivity type such that channel regions 105A-105N may each be portions of either a P-type or N-type transistor. Source and drain materials 106 are coupled together through channel regions 105A-105N. In the illustrated embodiment, each of channel regions 105 A-105N are operable to contribute to a total drive current of transistor structure 100. In transistor structure 100 the plurality of channel regions 105A-105N are operative in electrical parallel between source and drain materials 106. However, a transistor stack may instead comprise a plurality transistors that are operative independent of each other. For example, a first transistor may include channel region 105A and a second transistor may include channel region 105N, etc. For such embodiments, each electrically independent transistor within a transistor stack may include any integer number of channel regions (e.g., 1, 2... 5... 10, etc.) with a matching number of pairs of source and drain materials 106 that are electrically isolated from other pairs of source and drain materials 106. For example, transistor structure 100 may be replicated into first and second instances of transistor structure 100 with the second instance stacked over the first instance. For such embodiments, the two instances may comprise transistors of complementary conductivity type, for example. A first instance of source and drain etch stop layer 102 may be substantially as illustrated in FIG. 1, and a second instance of source and drain etch stop layer 102 may be between first and second instances of transistor structure 100. Alternatively, there may be no second instance of source and drain etch stop layer 102.

As described further below, source and drain etch stop layer 102 is of a chemical composition different from that of channel regions 105A-105N so that an etch of the channel material(s) and any intervening materials performed in preparation for the formation of source and drain materials 106 may be stopped on or within source and drain etch stop layer 102. Source and drain materials 106 may then be in contact with channel regions 105A-105N with a bottom of the source and drain materials 106 not extending down into substrate layer 101. Etch stop layer 102 is also of a chemical composition different from that of substrate layer 101. Accordingly, etch stop layer 102 may protect substrate layer 101 from the source and drain etch process as well as various other etch processes that may be performed after the source and drain etch but prior to formation of source and drain materials 106, for example to undercut channel regions 105A-105N.

In FIG. 1, two orthogonal planes A and B are demarked by dot-dash lines. Plane A is a "gate-cut" plane that passes through a transverse width of gate electrode 110 and passes through a longitudinal length of channel regions 105A-105N. Plane B is a "fin-cut" plane that passes through a transverse width of channel regions 105A-105N and passes through a longitudinal length of gate electrode 110. In the illustrated example, source and drain materials 106 comprise faceted epitaxial crystals that have been grown, for example from end portion of channel regions 105, and/or from source and drain etch stop layer 102 that is also monocrystalline and may have the same lattice orientation as channel regions 105A-105N. Source and drain materials 106 need not be epitaxial, in which case the facets shown in FIG. 1 may not be present. Source and drain materials 106 may not be merged into a unitary body as depicted, in which case cantilevered source and drain materials may be individually contacted by a terminal contact metal (not depicted). Although not depicted for the sake of clarity, front-side metallization levels 180 may include a source and/or drain contact that is in physical contact with at least one of source and drain materials 106. Likewise, front-side metallization levels 180 may further include a gate contact (not depicted) to gate electrode 110. Back-side metallization levels 190 may similarly include a source and/or drain contact that is in physical contact with at least one of source and drain materials 106, or a gate contact. With one of the source and drain material 106 illustrated in dashed line, gate electrode 110 and a gate insulator 107 can be seen to wrap completely around channel region 105A-105N.

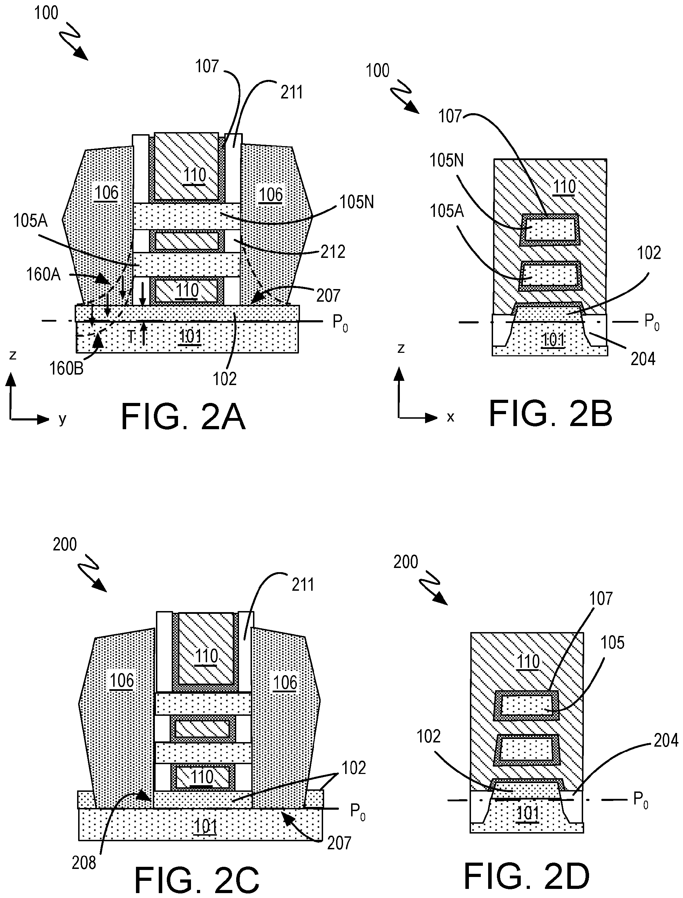

FIG. 2A illustrates a cross-sectional view of transistor stack structure 100 along the A-A' plane introduced in FIG. 1, in accordance with some embodiments. FIG. 2B illustrates a second cross-sectional view of transistor stack structure 100 along the B-B' plane introduced in FIG. 1, in accordance with some embodiments. As shown in FIG. 2A and 2B, channel regions 105A-105N are planar layers of semiconductor material that have been patterned into a fin over substrate layer 101. The trapezoidal profiles of channel regions 105A-105N illustrated in FIG. 2B are representative of structural asymmetry associated with front-side transistor fabrication. Such asymmetry may be a result of feature sidewall slopes that evolve during subtractive patterning of a fin, for example. Although channel regions 105A-105N are illustrated in FIG. 2B as nanoribbons having a transverse width greater than their vertical thickness, channel regions 105A-105N may be nanowires of substantially equal vertical thickness and lateral width, or nanoribbons having a transverse width less than their vertical thickness.

In some embodiments, channel regions 105A-105N are crystalline semiconductor. Although the crystalline semiconductor includes polycrystalline thin film material, the crystalline semiconductor may be advantageously monocrystalline. In some such embodiments, the crystallinity of channel regions 105A-105N is cubic with the top surfaces having crystallographic orientation of (100), (111), or (110), for example. Other crystallographic orientations are also possible. In some embodiments, channel regions 105A-105N are a substantially monocrystalline group IV semiconductor material, such as, but not limited to substantially pure silicon, silicon alloys (e.g., SiₓGe₁₋ₓ), or substantially pure germanium. Channel regions 105A-105N may also have any of these same exemplary compositions with alternative polycrystalline or amorphous microstructure, for example where transistor stack structure 100 has been fabricated from a thin film semiconductor material layer. Polycrystalline or amorphous embodiments of channel regions 105A-105N may also include semiconducting metal oxides, such as IGZO.

Source and drain materials 106 may similarly comprise any semiconductor material suitable for a transistor. In the illustrated embodiment, source and drain materials 106 are each a unified epitaxial semiconductor crystal. Source and drain materials 106 may be comprise one or more electrically active impurities. In some embodiments, for example, source and drain materials 106 are a Group IV semiconductor material (e.g., Si, Ge, or SiGe alloy) with at least one of a p-type impurity (e.g., boron or gallium) or an n-type impurity (e.g., phosphorus, arsenic, or antimony). In an exemplary IC comprising a plurality of transistor structures 100, source and drain materials 106 are silicon in an N-type subset of the plurality while source and drain materials 106 are SiGe in a P-type subset of the plurality.

As further illustrated in FIG. 2A and FIG. 2B, substrate layer 101 is under the stack of channel regions 105A-105N. Stop layer 102 is between a top, or uppermost, plane P₀ of substrate layer 101. Stop layer 102 is therefore in direct contact with substrate layer 101 with top plane P₀ being at the interface of stop layer 102 and substrate layer 101. Stop layer 102 and substrate layer 101 may both be considered sub-channel materials. In FIG. 2A, a tapered etch profile 160A is illustrated with a dashed line to represent a front of an exemplary source and drain etch performed prior in preparation for the formation of source and drain materials 106. Tapered etch profile 160A is what would ordinarily be generated by a non-selective etch process that is not advanced far enough and therefore results in channel region 105A being longer than channel region 105N. This difference in channel length can be detrimental to the operation of transistor structure 100. In the absence of stop layer 102, tapered etch profile is advanced below channel region 105A only by etching more of substrate layer 101, which, in turn would cause source and drain materials 106 to be deeper, as illustrated by tapered etch profile 160B. However, such deep etching of substrate layer 101 can be avoided with stop layer 102, and as shown in solid line, a bottom of source and drain materials 106 are in contact with stop layer 102, and channel region 105A is substantially the same length as channel region 105N.

Although stop layer 102 has the advantages illustrated in FIG. 2A, a fin etch that defines the transverse channel width of channel regions may, but need not, terminate on stop layer 102. For example, in FIG. 2B the fin etch that defined the transverse channel width of channel regions 105A-105N punched through stop layer 102 and into substrate layer 101. Stop layer 102 and some portion of substrate layer 101 below top plane P₀ are therefore a sub-channel portion the fin. An insulator 204 is adjacent to a sidewall of stop layer 102 and a sidewall of some portion of substrate layer 101 below top plane P₀. In alternative embodiments, a fin etch that defines the transverse channel width of channel regions 105A-105N may instead stop on, or within, stop layer 102 so that stop layer 102 is not fully defined as a base of the fin.

Substrate layer 101 may have a composition and/or microstructure similar to channel regions 105A-105N. For example, in some embodiments where channel regions 105 are of a Group IV material (e.g., silicon), substrate layer 101 is also a Group IV material (e.g., silicon). In some further embodiments where channel regions 105A-105N are substantially monocrystalline, substrate layer 101 is also substantially monocrystalline, and has the same crystallinity and/or crystal orientation as that of channel regions 105A-105N. Substrate layer 101 may also comprise one or more buffer layers, which may be either Group IV, Group III-N, or Group III-V materials, for example.

Etch stop layer 102 advantageously has the same crystallinity and/or crystal orientation as that of channel regions 105A-105N and substrate layer 101. The composition of etch stop layer 102 is however distinct from that of both substrate layer 101 and channel regions 105A-105N. Stop layer 102 preferably comprises only intrinsic levels of acceptor or donor impurities so as to have highest electrical resistivity.

In some exemplary embodiments, etch stop layer 102 comprises silicon and carbon. Etch stop layer 102 may be primarily silicon (i.e., silicon-rich) with carbon being a secondary constituent of a lower (but non-zero) concentration. Alternatively etch stop layer may be primarily carbon (i.e., carbon-rich) with silicon being a secondary constituent of a lower (but non-zero) concentration. In some embodiments where etch stop layer 102 is primarily silicon, etch stop layer 102 is carbon-doped silicon (Si:C) having less than approximately 5 at. % carbon. Carbon concentration within etch stop layer 102 may also be significantly greater, for example ranging from 10 at. % to 75 at. %, with etch stop layer 102 becoming SiC (e.g., 3C-SiC).

The inclusion of carbon in etch stop layer 102 advantageously improves the stop layer's resistance to many etchants suitable for channel regions 105A-105N. For example, etch stop layer 102 may have as little as 0.5-1.5 at. % carbon and still result in significantly more etch resistance than channel regions comprising pure silicon or a SiGe alloy. With sufficient etch resistance, source and drain materials 106 may be in direct contact with only a top surface 207 of stop layer 102. For embodiments where stop layer 102 separates source and drain materials 106 from substrate layer 101 (e.g., as illustrated in FIG. 2A-2B), impurities present within source and drain material 106 may be confined by etch stop layer 102 further functioning as a diffusion barrier. The inclusion of carbon, for example, can advantageously reduce the diffusivity of electrically active dopants within silicon.

Generally, the bandgap of a silicon-carbon etch stop layer will increase from that of silicon (e.g., 1.12eV) to that of silicon carbide (3C-SiC) as carbon concentration increases. The bandgap of lightly doped Si:C (e.g., 0.5-1.5 at. %) may be substantially the same as that of silicon, or even slightly smaller where the carbon is highly substitutional. The bandgap of 3C-SiC may vary from about 2.2eV to 3.3eV for 40-75 at. % C. A stop layer with a larger bandgap may therefore present a larger Fermi barrier, which may also impede leakage current between source and drain materials 106.

A source and drain stop layer of Si:C or 3C-SiC is well-suited to Group IV channel material(s) and substrate layer. However, stop layer 102 may also have other compositions. For example, in some embodiments, stop layer 102 is a III-N material such as GaN or AlN, or a III-V material, such as GaAs or InGaAs. III-N or III-V embodiments may be particularly well-suited to embodiments where channel regions 105A-105N and/or substrate layer 101 are also a III-N or III-V materials.

As illustrated in FIG. 2A, source and drain etch stop layer 102 has a thickness T, which may vary with implementation, for example as a function of the etch resistance afforded by the composition of the stop layer. In embodiments where etch stop layer 102 is under significant lattice strain, thickness T is below the critical thickness so that etch stop layer 102 is pseudomorphic rather than metamorphic. In some embodiments, thickness T is at least 2 nm. Thickness T is advantageously less than 20 nm, although greater thicknesses may also be possible.

As further shown in FIG. 2A and 2B, transistor stack structure 100 includes a gate stack comprising gate electrode 110 and gate insulator 107 cladding channel regions 105A-105N to provide gate-all-around control of channel conductivity. For the illustrated embodiments, gate electrode 110 is depicted as a single homogeneous metal. In some embodiments, gate electrode 110 includes an n-type work function metal, which may have a work function between about 3.9 eV and about 4.2 eV, for example. Suitable n-type work function metals include, but are not limited to, hafnium, zirconium, titanium, tantalum, aluminum, and metal carbides that include these elements (e.g., titanium carbide, zirconium carbide, tantalum carbide, hafnium carbide and aluminum carbide). In some other embodiments, gate electrode 110 includes a p-type work function metal, which may have a work function between about 4.9 eV and about 5.2 eV, for example. Suitable p-type materials include, but are not limited to, ruthenium, palladium, platinum, cobalt, nickel titanium, tungsten, conductive metal nitrides (e.g., TiN, WN), and conductive metal oxides (e.g., ruthenium oxide). In still other embodiments, gate electrode 110 may instead include only a mid-gap work function metal having a work function between those of the n-type and p-type work function metals (e.g., 4.2-4.9eV). Although not illustrated, a compositionally distinct gate fill metal may be over a work function metal where a thickness of the work function metal does not fully occupy the volume allocated to gate electrode 110.

As further illustrated in FIG. 2A and FIG. 2B, gate insulator 107 completely surrounds channel regions 105A-105N. Gate insulator 107 may include a thermal (chemical) oxide that is present only on surfaces of channel regions 105A-105N. The chemical oxide layer may comprise predominantly silicon and oxygen, for example. Hence, gate insulator 107 may be a stack of both a chemical oxide layer and a high-k insulator layer. The high-k insulator layer may be of a material having a bulk relative permittivity greater than 8. One exemplary high-k material is metal oxide (MOₓ). Examples include a metal oxide comprising predominantly aluminum (e.g., AlOₓ), a metal oxide comprising predominantly magnesium (e.g., MgO), a metal oxide comprising predominantly lanthanum (e.g., LaOₓ), a metal oxide comprising predominantly hafnium (e.g., HfOₓ), or metal oxide comprising predominantly zirconium (e.g., ZrOₓ). In other examples, the high-k material is an alloyed metal oxide comprising significant portions of two or more metals (e.g., HfAlOₓ, HfZrOₓ). In some further embodiments, high-k material further includes silicon. For example, metal silicates, such as, but not limited to HfSiOₓ, or ZrSiOₓ, may also be suitable a high-k gate insulator for some channel compositions (e.g., Si, Ge, SiGe, III-V). Some specific examples of other suitable high-k gate dielectric materials include lanthanum aluminum oxide, tantalum silicon oxide, tantalum oxide, titanium oxide, barium strontium titanium oxide, barium titanium oxide, strontium titanium oxide, yttrium oxide, lead scandium tantalum oxide, and lead zinc niobate.

FIG 2C and FIG. 2D further illustrate a transistor stack structure 200 along the same two gate-cut and fin-cut cross-sectional planes illustrated in FIG. 2A and FIG. 2B, respectively. In the exemplary embodiments, transistor stack structure 200 similarly includes source and drain etch stop layer 102. However, as shown, source and drain materials 106 are within a recess extending through etch stop layer 102. A bottom of source and drain materials 106 is therefore coincident with substrate layer top plane P₀. Source and drain materials 106 are adjacent to a sidewall 208 of etch stop layer 102, and in the illustrated embodiment, are in direct contact with stop layer sidewall 208. Source and drain materials 106 are also in direct contact with substrate layer 101. Nevertheless, in the manufacture of structure 200, a source and drain etch exposing stop layer 102 may be stopped upon stop layer 102 substantially as described above for stack structure 100. Following the stop, a short etch of stop layer 102 may be performed to expose substrate layer 101 so that source and drain materials 106 are not significantly below substrate layer top plane P₀. Transistor structure 200 is therefore an extreme example of how source and drain material may be a least partially recessed within stop layer 102. Stop layer 102 may, in this example, provide less of a diffusion barrier to dopants migrating from source and drain material 106 into substrate layer 101.

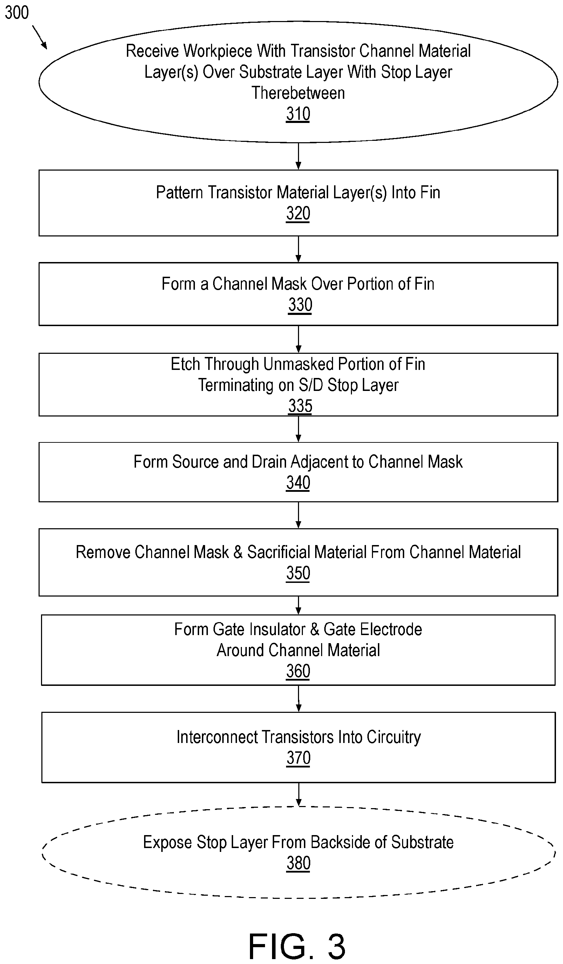

FIG. 3 is a flow diagram illustrating methods 300 for fabricating a transistor stack structure including a source and drain stop layer, in accordance with some embodiments. Through the practice of methods 300, transistors within transistor stack structures may provide improve performance, displaying for example less source/drain leakage. Methods 300 begin at input 310 where a workpiece, such as a large format (e.g., 300 mm, or more) wafer is received. The workpiece includes one or more layers of transistor channel material over a planar surface of a substrate layer with a stop layer therebetween. Where there is more than one layer of channel material, channel material layers may be separated by a sacrificial crystalline material.

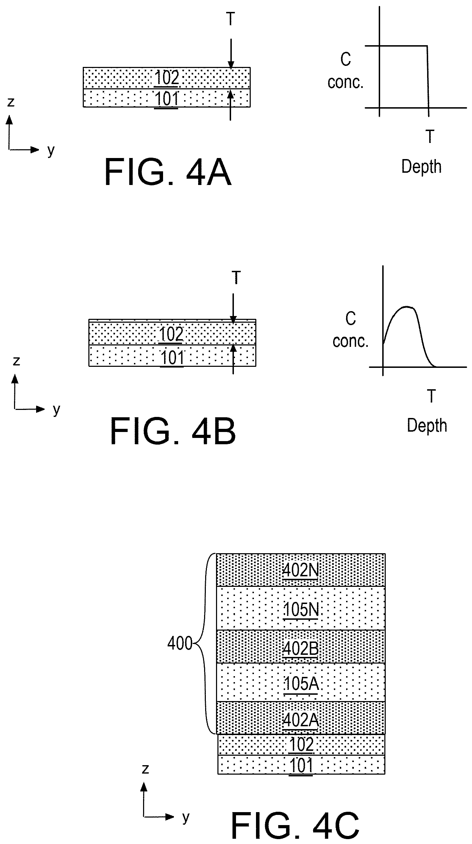

The workpiece received at input 310 may be fabricated upstream of methods 300, for example. FIG. 4A-4C are cross-sectional views through a workpiece being fabricated to include stop layer 102. Optionally, the operations illustrated by FIG. 4A-4C may be incorporated into methods 300. In FIG. 4A, stop layer 102 is epitaxially grown upon the planar surface of substrate layer 101. For some exemplary embodiments, a Si:C or SiC stop layer 102 is epitaxially grown upon a silicon plane of a monocrystalline silicon substrate layer 101. A carbon precursor is introduced in-situ with silicon precursor during the epitaxial growth to achieve a target carbon concentration. As depicted, a model carbon concentration depth profile for such an epitaxially grown stop layer is substantially flat near the target concentration throughout nearly the entire stop layer thickness T. FIG. 4B illustrates alternative embodiments where carbon is introduced by ion implantation into substrate layer 101. Following a thermal activation anneal, a model carbon concentration depth profile for such an implanted stop layer is more Gaussian than for epitaxial embodiments. As depicted, the peak (target) concentration is somewhere below the stop layer surface, but within stop layer thickness T.

Following formation of the stop layer, channel material layer(s) may be epitaxially grown over the stop layer. As few as a single channel material layer may be grown. In the example embodiment illustrated in FIG. 4C, a transistor channel material stack 400 including a plurality of bi-layers comprising sacrificial material layers 402A, 402B, 402N and channel material layers 105A, 105N is grown over stop layer 102. In some embodiments, the sacrificial material layers 402A-402N include more germanium than channel material layers 105A-105N. For example, where the channel material layers 105A-105N are substantially pure silicon, sacrificial layers 402A-402N are Si₁₋ₓGe_{X}. In specific examples, X may be between 0.15-0.6.

Returning to FIG. 3, methods 300 continue at block 320 where the transistor channel material(s) is patterned into a fin. Any patterning process, such as a spacer-based lithographic pitch-reduction patterning process, may be practiced at block 320. Any subtractive etch may be practiced at block 320 to delineate a fin into the channel material. In some embodiments, a plasma etch process may be utilized to define fins. The patterning process carried out at block 320 may also etch a portion of the underlying substrate layer (e.g., silicon).

At block 330 a portion of the fin patterned at block 320 is protected with a channel mask. The channel mask may include one or more material layers. Prior to forming the channel mask, a dielectric material may be formed over the fins of stacked channel materials, and on sidewalls of the fins. The dielectric may then be planarized so a top surface of the dielectric material is substantially coplanar with a top surface of the fin. The planar dielectric material may be recessed to a level at, or below, one or more of the channel materials in the stack. In some embodiments, the channel mask formed over exposed portions of the fin includes a sacrificial gate stack, for example further including a dielectric layer such as silicon oxide, or Al₂O₃, and any other material, such as, but not limited to polysilicon. Optionally, a spacer dielectric may be formed over the channel mask and anisotropically etched to form a spacer around the channel mask.

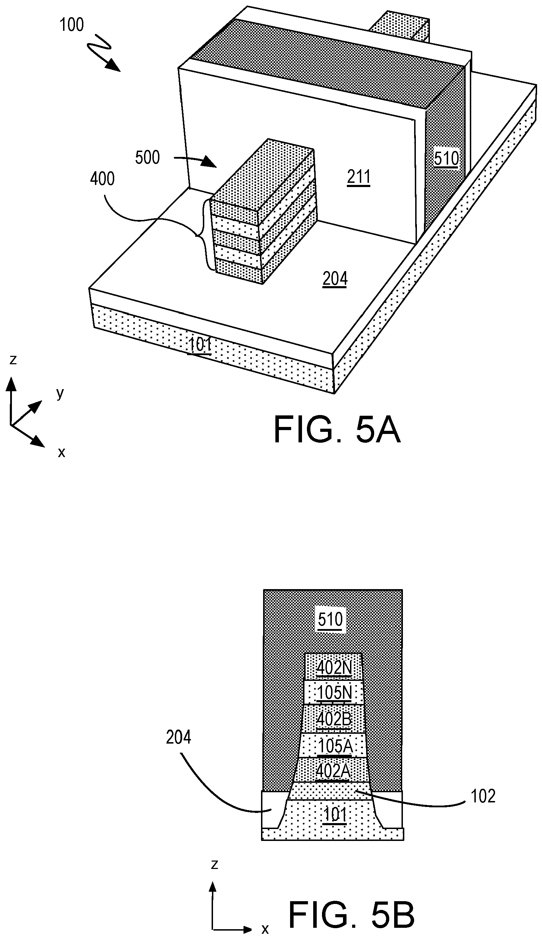

FIG. 5A is an isometric view of an exemplary fin 500 comprising stacked semiconductor material layers 400, in accordance with some embodiments. Channel mask 510 may include one or more material layers. Prior to forming channel mask 510, insulator 204 was formed over fin 500. FIG. 5A further illustrates spacer dielectric 211 adjacent to channel mask 510. FIG. 5B is a cross-sectional view through a width of fin 500 and a length of a channel mask 510 illustrated in FIG. 5A, in accordance with some embodiments. As shown, isolation material 204 is adjacent to a sidewall of both stop layer 102 and substrate layer 101, as a result of the fin etch punching through stop layer 102. Because of the depth of the fin etch, isolation material 204 is retained between channel mask 510 and substrate layer 101.

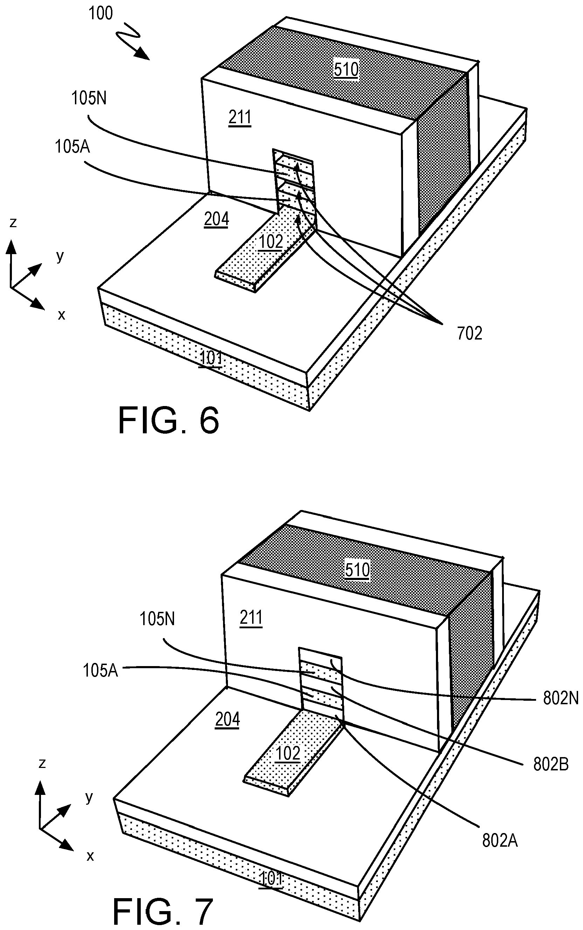

Returning to FIG. 3, methods 300 continue at block 335 where channel material layer(s) are etched within regions of the fin where source and drain materials are to be formed. Any etch process(es) known to be suitable for the fin material(s) that are further selective to the stop layer may be practiced at block 335. In some exemplary embodiments, a fluorine-based plasma etch is performed to etch through Si and/or Ge fin material layers. Block 335 may further comprise any desired undercutting of channel material, and/or formation of additional spacer dielectric. FIG. 6 is an isometric view of fin 500 following a source and drain etch which removed material stack 400 selectively to stop layer 102, in accordance with some embodiments. As further illustrated, sacrificial material layers 402A-402N have been recessed from an outer sidewall of spacer dielectric 211, leaving ends of channel regions 105A-105N proud of sacrificial material layers 402A-402N. FIG. 7 further illustrates spacer dielectric 802A-802N filling in undercut gaps 702 between ends of channel regions 105A-105N.

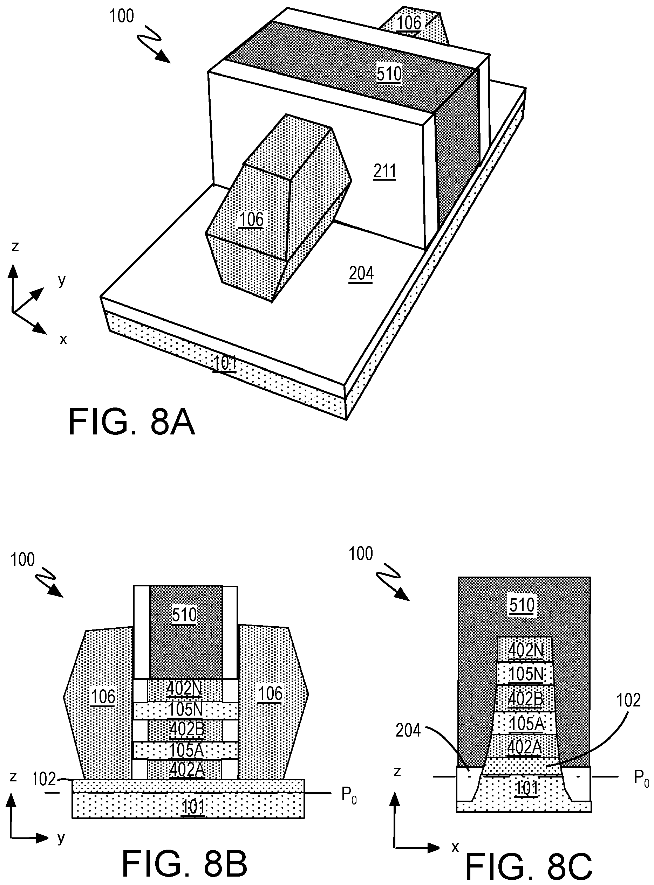

Methods 300 (FIG. 3) continue at block 340 where source and drain materials are formed adjacent to the channel mask and/or spacer dielectric. Source and drain material may be deposited or epitaxially grown in contact with the channel regions, substantially as further illustrated in FIG. 8A-8C. In some embodiments, the source and drain materials 106 are epitaxially grown by a low pressure CVD (LPCVD) process with acceptor or donor impurities introduced in-situ to the growth. In PMOS embodiments, source and drain materials 106 are predominantly silicon or Si₁₋ₓGe_{X} (e.g., where X is between 0.2-0.65) with one or more p⁺ dopants, such as boron, gallium, indium, or aluminum. In NMOS embodiments, source and drain material 106 is grown to include predominantly silicon, and one or more n-dopants such as phosphorus, arsenic, or antimony. In CMOS embodiments, both P-type and N-type source and drain materials may be formed for different subsets of a plurality of fins. As shown in FIG. 8B, source and drain materials were grown in direct contact with stop layer 102. Stop layer 102, being crystalline, may therefore have served as a seeding surface for the epitaxy of source and drain material 106 with the depth of source and drain materials 106 being less than top substrate layer plane P, for example as described above.

Returning to FIG. 3, methods 300 continue at block 350 where the channel mask is removed the fin and sacrificial material layer(s) stripped from between channel regions of the exposed stack of material bi-layers. In some embodiments, the sacrificial layers are selectively removed from intervening channel materials with wet chemical etch process to expose the channel material as ribbon or wires.

Following the exposure of transistor channel regions, methods 300 continue with the formation of gate insulator(s) and gate electrode(s) at block 360, for example using any techniques known in the art. In some embodiments, chemical oxidation and/or atomic layer deposition processes form the gate insulator while the gate electrode may be formed by ALD or CVD of one or more metals, for example. At block 370, the transistor structure is then substantially complete and may be interconnected with other transistor structures through one or more levels of interconnect metallization according to any backend of line (BEOL) fabrication processes known to be suitable for integrated circuits (ICs).

Methods 300 may be optionally concluded with back-side processing of the workpiece, for example with thinning or etching of the substrate layer from the back side to expose a back side of the stop layer. For such embodiments, the compositional distinction between the stop layer and the substrate layer may be further utilized to terminate a back-side substrate layer etch at a precise depth defined by the stop layer, which is very near the transistor source and drain materials (as well as the gate electrode). Once a back side of the stop layer exposed, any of these transistor terminal materials may be exposed with a further short (e.g., timed) etch of the stop layer. Back-side interconnect may then be fabricated according to any techniques known in the art.

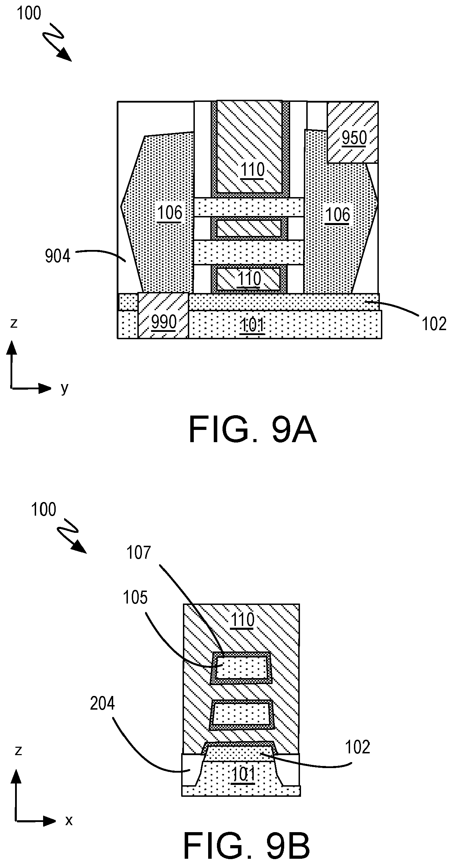

FIG. 9A and 9B illustrate cross-sectional views of transistor stack structure 100 following fabrication of frontside and backside interconnects. As shown in FIG. 9A, front-side interconnects comprises contact metallization 950 to at least a drain material 106 isolated by an overlying dielectric material 904. Back-side interconnects comprise contact metallization 990 to at least source material 106. The buried stop layer 102 may therefore be levered from both sides of transistor stack structure 100.

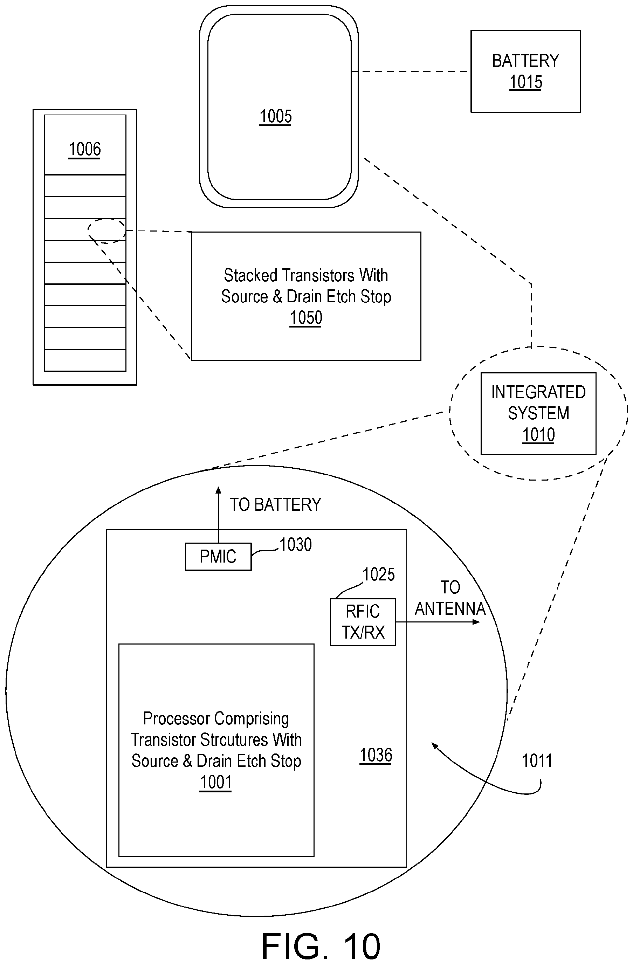

The transistor structures with buried source and drain etch stop layers, and the methods of forming such structures, described herein may be integrated into a wide variety of ICs and computing systems that include such ICs. FIG. 10 illustrates a system in which a mobile computing platform 1005 and/or a data server machine 1006 employs an IC having a memory and/or microprocessor IC with one or more transistor structures including a buried source and drain etch stop layer, for example in accordance with some embodiments described elsewhere herein. In some embodiments, the transistor structure is coupled to an I/O of the memory and/or microprocessor IC. The server machine 1006 may be any commercial server, for example including any number of high-performance computing platforms within a rack and networked together for electronic data processing, which in the exemplary embodiment includes system 1050, which may be implemented as a monolithic IC or heterogeneous chip assembly. The mobile computing platform 1005 may be any portable device configured for each of electronic data display, electronic data processing, wireless electronic data transmission, or the like. For example, the mobile computing platform 1005 may be any of a tablet, a smart phone, laptop computer, etc., and may include a display screen (e.g., a capacitive, inductive, resistive, or optical touchscreen), a chip-level integrated system 1010, and a battery 1015.

Whether disposed within the integrated system 1010 illustrated in the expanded view 1011, or as a stand-alone packaged chip within the server machine 1006, system 1050 may include memory circuitry (e.g., RAM), and/or a logic circuitry (e.g., a microprocessor, a multi-core microprocessor, graphics processor, or the like). At least one of these circuitries further includes one or more transistor structures including source and drain etch stop layer, for example in accordance with some embodiments described elsewhere herein. System 1050 may be further include and processor IC 1010 coupled to a board or package substrate layer 1036 that further hosts one or more additional ICs, such as power management IC 1030 and radio frequency IC 1025. RFIC 1025 may have an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond.

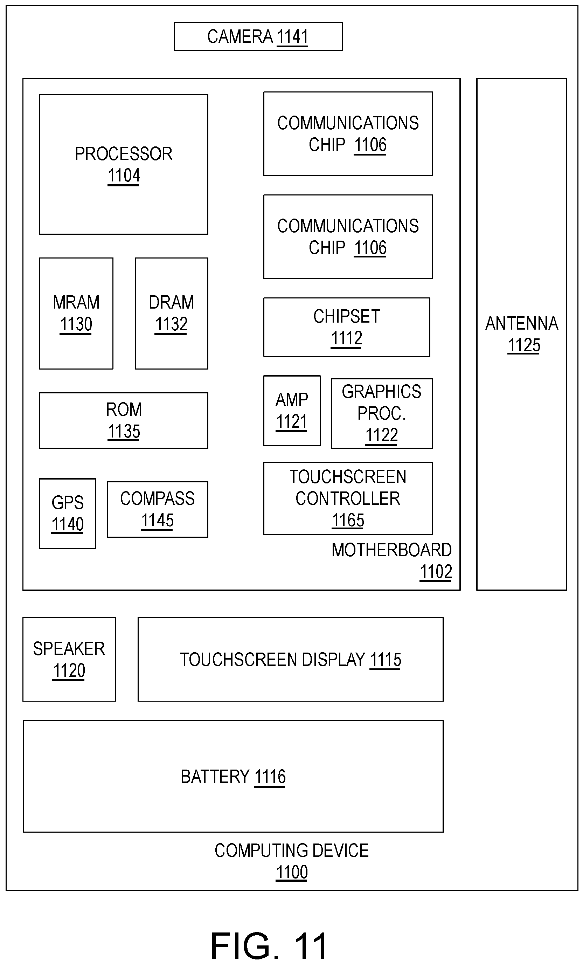

FIG. 11 is a functional block diagram of an electronic computing device 1100, in accordance with some embodiments. Device 1100 further includes a motherboard 1102 hosting a number of components, such as, but not limited to, a processor 1104 (e.g., an applications processor). Processor 1104 may be physically and/or electrically coupled to motherboard 1102. In some examples, processor 1104 is part of an IC including one or more transistor structures including a source and drain stop layer, for example in accordance with some embodiments described elsewhere herein. In general, the term "processor" or "microprocessor" may refer to any device or portion of a device that processes electronic data from registers and/or memory to transform that electronic data into other electronic data that may be further stored in registers and/or memory.

In various examples, one or more communication chips 1106 may also be physically and/or electrically coupled to the motherboard 1102. In further implementations, communication chips 1106 may be part of processor 1104. Depending on its applications, computing device 1100 may include other components that may or may not be physically and electrically coupled to motherboard 1102. These other components include, but are not limited to, volatile memory (e.g., DRAM 1132), non-volatile memory (e.g., ROM 1135), flash memory (e.g., NAND or NOR), magnetic memory (MRAM 1130), a graphics processor 1122, a digital signal processor, a crypto processor, a chipset 1112, an antenna 1125, touchscreen display 1115, touchscreen controller 1165, battery 1116, audio codec, video codec, power amplifier 1121, global positioning system (GPS) device 1140, compass 1145, accelerometer, gyroscope, speaker 1120, camera 1141, and mass storage device (such as hard disk drive, solid-state drive (SSD), compact disk (CD), digital versatile disk (DVD), and so forth, or the like.

Communication chips 1106 may enable wireless communications for the transfer of data to and from the computing device 1100. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chips 1106 may implement any of a number of wireless standards or protocols, including, but not limited to, those described elsewhere herein. As discussed, computing device 1100 may include a plurality of communication chips 1106. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described, but can be practiced with modification and alteration without departing from the scope of the appended claims. For example, the above embodiments may include specific combinations of features as further provided below.

In first examples, a transistor structure comprises a substrate layer comprising monocrystalline silicon. The structure comprises a stop layer over an uppermost plane of the substrate layer, wherein the stop layer is monocrystalline and of a different composition than the substrate layer. The structure comprises a fin comprising a channel layer over a plane of the stop layer. The channel layer is monocrystalline and of a different composition than the stop layer. The structure comprises a gate insulator and gate electrode adjacent to at least a sidewall of the channel layer. The structure comprises source and drain materials in contact with the channel layer at opposite sides of the gate electrode, wherein the source and drain materials are in contact with the stop layer and a bottom of the source and drain materials is at, or above, the uppermost plane of the substrate layer.

In second examples, for any of the first examples, the stop layer comprises at least one of Si, Al, Ga, In, or As.

In third examples, for any of the first through second examples the stop layer comprises nitrogen or carbon.

In fourth examples, for any of the first through third examples the stop layer comprises primarily Si and C.

In fifth examples, for any of the first through fourth examples the stop layer comprises less than 5 at. % C.

In sixth examples, for any of the first through fifth examples the stop layer comprises 5-75 at. % C.

In seventh examples, for any of the third through sixth examples, the stop layer comprises AlN or GaN.

In eighth examples, for any of the first through seventh examples the stop layer has a thickness of at least 1nm.

In ninth examples, for any of the first through eighth examples the stop layer has a thickness less than 20 nm.

In tenth examples, for any of the first through ninth examples the source and drain materials are in direct contact with the top plane of the substrate layer.

In eleventh examples, for any of the tenth examples the source and drain materials are within a recess in the stop layer, a bottom of the source and drain materials in direct contact with a sidewall of the stop layer.

In twelfth examples, for any of the first through eleventh examples the channel layer comprises a monocrystalline material comprising at least one of Si or Ge, and the source and drain materials are monocrystalline and comprise at least one of Si or Ge.

In thirteenth examples, a computer system comprises a power supply, and an IC die coupled to the power supply. The IC die comprises a transistor structure comprising a substrate layer comprising monocrystalline silicon. The structure comprises a stop layer over an uppermost plane of the substrate layer, wherein the stop layer is monocrystalline and of a different composition than the substrate layer. The structure comprises a fin comprising a channel layer over a plane of the stop layer. The channel layer is monocrystalline and of a different composition than the stop layer. The structure comprises a gate insulator and gate electrode adjacent to at least a sidewall of the channel layer. The structure comprises source and drain materials in contact with the channel layer at opposite sides of the gate electrode. The source and drain materials are in contact with the stop layer and a bottom of the source and drain materials is at, or above, the uppermost plane of the substrate layer.

In fourteenth examples, for any of the thirteenth examples the stop layer comprises Si and less than 5 at. % C.

In fifteenth examples, for any of the thirteenth through fourteenth examples the system further comprises a battery coupled to the power supply.

In sixteenth examples, a method of fabricating an IC comprises receiving a workpiece with a transistor channel material over a substrate layer and a stop layer therebetween. The method comprises patterning the channel material into a fin. The method comprises forming a mask over a channel portion of the fin. The method comprises exposing the stop layer at opposite sides of the mask by etching through the channel material. The method comprises forming source and drain materials on the opposite sides of the mask and in contact with the channel material. The method comprises replacing the mask with a gate stack comprising a gate dielectric and a gate electrode.

In seventeenth examples, for any of the sixteenth examples forming the source and drain materials further comprises epitaxially growing a crystalline material in contact with the stop layer.

In eighteenth examples, for any of the sixteenth through seventeenth examples the method comprises etching the stop layer selectively to the substrate layer to expose a planar surface of the substrate layer.

In nineteenth examples, for any of the sixteenth through eighteenth examples the stop layer comprises at least one of Si, Al, Ga, In, or As.

In twentieth examples, for any of the sixteenth through nineteenth examples the stop layer comprises Si and less than 5 at. % C.

In twenty-first examples, for any of the sixteenth through twentieth examples the method comprises exposing a back side of the stop layer by etching through the substrate layer from a back side of the substrate layer, and etching through the stop layer from the back side to expose a bottom of at least one of the source and drain materials.

However, the above embodiments are not limited in this regard and, in various implementations, the above embodiments may include the undertaking of only a subset of such features, undertaking a different order of such features, undertaking a different combination of such features, and/or undertaking additional features than those features explicitly listed. The scope of the invention should, therefore, be determined with reference to the appended claims, along with the full scope of equivalents to which such claims are entitled.

## Claims

1. A transistor structure comprising:
a substrate layer comprising monocrystalline silicon;
a stop layer over an uppermost plane of the substrate layer, wherein the stop layer is monocrystalline and of a different composition than the substrate layer;
a fin comprising a channel layer over a plane of the stop layer, wherein the channel layer is monocrystalline and of a different composition than the stop layer;
a gate insulator and gate electrode adjacent to a sidewall of the channel layer; and
source and drain materials in contact with the channel layer at opposite sides of the gate electrode, wherein the source and drain materials are in contact with the stop layer and a bottom of the source and drain materials is at, or above, the uppermost plane of the substrate layer.

2. The transistor structure of claim 1, wherein the stop layer comprises at least one of Si, Al, Ga, In, or As.

3. The transistor structure of claim 2, wherein the stop layer comprises nitrogen or carbon.

4. The transistor structure of claim 3, wherein the stop layer comprises primarily Si and C.

5. The transistor structure of claim 4, wherein the stop layer comprises less than 5 at. % C.

6. The transistor structure of claim 4, wherein the stop layer comprises 5-75 at. % C.

7. The transistor structure of claim 3, wherein the stop layer comprises AlN or GaN.

8. The transistor structure of any one of claims 1-7, wherein the stop layer has a thickness of at least 1nm.

9. The transistor structure of claim 8, wherein the stop layer has a thickness less than 20 nm.

10. The transistor structure of any one of claims 1-9, wherein the source and drain materials are in direct contact with the top plane of the substrate layer.

11. The transistor structure any one of claims 1-10, wherein the source and drain materials are within a recess in the stop layer, a bottom of the source and drain materials in direct contact with a sidewall of the stop layer, wherein the channel layer comprises a monocrystalline material comprising at least one of Si or Ge, and wherein the source and drain materials are monocrystalline and comprise at least one of Si or Ge.

12. A computer system, comprising:
a power supply; and
an IC die coupled to the power supply, wherein the IC die comprises a transistor structure comprising:
a substrate layer comprising monocrystalline silicon;
a stop layer over an uppermost plane of the substrate layer, wherein the stop layer is monocrystalline and of a different composition than the substrate layer;
a fin comprising a channel layer over a plane of the stop layer, wherein the channel layer is monocrystalline and of a different composition than the stop layer; a gate insulator and gate electrode adjacent to at least a sidewall of the channel layer; and
source and drain materials in contact with the channel layer at opposite sides of the gate electrode, wherein the source and drain materials are in contact with the stop layer and a bottom of the source and drain materials is at, or above, the uppermost plane of the substrate layer.

13. The computer system of claim 12, wherein the stop layer comprises Si and less than 5 at. % C.

14. A method of fabricating an IC, the method comprising:
receiving a workpiece with a channel material over a substrate layer and a stop layer therebetween;
patterning the channel material into a fin;
forming a mask over a channel portion of the fin;
exposing the stop layer adjacent to the mask by etching through the channel material;
forming source and drain materials adjacent to the mask and in contact with the channel material; and
replacing the mask with a gate stack comprising a gate dielectric and a gate electrode.

15. The method of claim 14, wherein the method further comprises:
exposing a back side of the stop layer by etching through the substrate layer from a back side of the substrate layer; and
etching through the stop layer from the back side to expose a bottom of at least one of the source and drain materials.
